# EUROPEAN PATENT SPECIFICATION

(11) **EP 2 348 524 B1**
(45) Date of publication and mention of the grant of the patent: **20.03.2019**
(21) Application number: 11151363.6
(22) Date of filing: 19.01.2011
(51) Int. Cl.: H01L 21/02

(54) **Method for recovering pattern on silicon substrate**
Verfahren zur Wiederherstellung eines Musters auf einem Siliziumsubstrat
Procédé de récupération d'un motif sur un substrat de silicium

(30) Priority: 20.01.2010 JP 2010009979
(43) Date of publication of application: 27.07.2011
(73) Proprietor: TOKYO ELECTRON LIMITED, Minato-ku Tokyo 107-6325 (JP)
(72) Inventor: Nishimura, Eiichi, Yamanashi 407-0192 (JP); Tahara, Shigeru, Yamanashi 407-0192 (JP); Yamashita, Fumiko, Yamanashi 407-0192 (JP)
(74) Representative: Hoffmann Eitle

(56) References cited:
- US-A1- 2005 085 090
- US-A1- 2008 176 396
- US-A1- 2008 182 421
- US-A1- 2009 000 640
- US-A1- 2009 191 340

## Description

### Field of the Invention

The present invention relates to a pattern forming method.

### Background of the Invention

In a semiconductor device manufacturing process, fine circuit patterns are formed on a silicon substrate (semiconductor wafer) by a photolithography process. In the photolithography process, predetermined patterns, e.g., lines, holes or the like, are formed on a silicon substrate by a process for coating, exposing and developing a photoresist, an etching process using the photoresist as a mask, and the like.

When the etching is performed in the photolithography process, a polymer (so-called sidewall polymer) may be adhered to sidewalls of the patterns. As for a technique for removing the sidewall polymer, there has been known a wet cleaning technique using a cleaning fluid including hydrogen fluoride, methanol and the like (see, e.g., Japanese Patent Application Publication No. H11-340183).

Further, as for a technique for removing a native oxide film formed in a contact hole, there has been known a technique using mixed vapor of hydrogen fluoride and alcohol (see, e.g., Japanese Patent Application Publication No. H5-47742).

As described above, there have been conventionally known the technique for removing the sidewall polymer generated during the photolithography process or the technique for removing the native oxide film formed in the contact hole by supplying mixed vapor.

Meanwhile, along with the trend toward formation of ultra-fine circuit patterns in a semiconductor device, a line width of the patterns formed by the photolithography process tends to be reduced from, e.g., about 56 nm to about 43 nm and further to about 32 nm. However, the formation of the ultra-fine patterns causes the following problems.

In case line-shaped patterns having a line width of, e.g., about 32 nm or less are formed on a silicon substrate, if the silicon substrate is left in the air after the etching process, the spaces between the patterns are filled with foreign substances grown therein so that the patterns adjacent to each other are connected through the foreign substances. Further, if the silicon substrate is left in the air for a long period of time, the foreign substance grown between the patterns may cause collapse of the patterns. It is believed that the foreign substances may be generated by reaction between halogen elements or the like remaining in the patterns during etching and ammonia or the like in air. Further, it is believed that the phenomenon in which the spaces between the patterns are filled with the foreign substances or the patterns collapse due to the fine widths of the patterns and the spaces between the patterns.

In case of fine patterns having about 32 nm line width and space, if a wet cleaning process is performed, the patterns are adhered to each other during the cleaning. It is believed that such phenomenon occurs mainly because the patterns collapse due to surface tension of liquid and partially because residual components of a watermark act as an adhesive. Hence, in case of the fine patterns having about 32 nm line width and space, it is not proper to perform the wet etching.

As described above, in case the fine patterns having the line width and space of about 32 nm or less are formed on a silicon substrate, the spaces between the patterns may be filled with the foreign substance, or the foreign substances may cause collapse of the patterns. Further, in this case, it is not proper to perform the wet etching process. Conventionally, the silicon substrate in which such phenomenon occurs has been destroyed. Therefore, it is required to develop a method and an apparatus capable of recovering a shape of patterns on a silicon substrate by removing foreign substance grown between the patterns.

Further prior art is known from US 2008/176396 A1; US 2009/000640 A1; US 2008/182421 A1; US 2009/191340 A1; and US 2005/085090 A1.

### Summary of the Invention

According to the present invention, there is provided a pattern forming method as defined in claim 1.

Embodiments of the present invention can provide a method capable of recovering a shape of patterns, formed on a silicon substrate by etching, by removing foreign substance frown between the patterns.

### Brief Description of the Drawings

To enable a better understanding of the present invention, and to show how the same may be carried into effect, reference will now be made, by way of example only, to the accompanying drawings, in which;-
Fig. 1 schematically shows an example of patterns in order to explain a method for recovering patterns on a silicon substrate in accordance with an embodiment of the present invention;
Figs. 2A to 2C explain the method for recovering patterns on a silicon substrate in accordance with the embodiment of the present invention; and
Fig. 3 schematically shows a configuration of an apparatus for recovering patterns on a silicon substrate.

### Detailed Description of the Embodiments

An embodiment of the present invention will be described with reference to the accompanying drawings which form a part hereof.

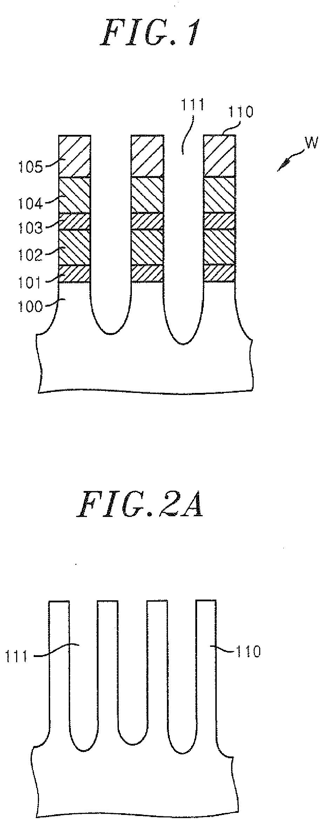

Fig. 1 schematically shows an example of patterns to be recovered by a method in accordance with the embodiment of the present invention. As shown in Fig. 1, patterns 110, which are formed of lines spaced apart from each other at regular intervals, are formed on a silicon substrate (semiconductor wafer) W by etching. Further, spaces 111 are formed between the patterns 110. In the invention, the widths of the patterns 110 and the spaces 111 are not greater than about 32 nm.

Each of the patterns 110 on a silicon substrate W includes, e.g., a single crystal silicon layer 100, an SiO₂ layer 101, a polysilicon layer 102, an SiO₂ layer 103, an SiN layer 104, an SiO₂ layer 105 and the like which are laminated in that order from the bottom.

Hereinafter, a method for recovering patterns on a silicon substrate in accordance with the embodiment of the present invention will be described with reference to Figs. 2A to 2C. As shown in Fig. 2A, upon completion of an etching process, the spaces 111 are formed between the patterns 110, and the patterns 110 are separated from each other.

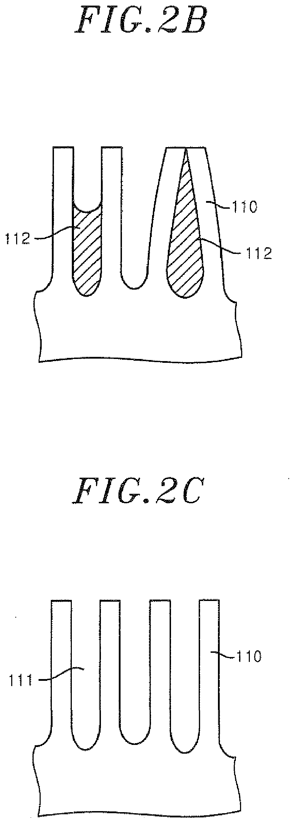

If the etched silicon substrate W is left in the air, foreign substances 112 are grown between the patterns 110, as shown in Fig. 2B. Further, as shown in the left side of Fig. 2B, the spaces 111 between the patterns 110 are filled with the foreign substances 112 so that the patterns 110 adjacent to each other are connected through the foreign substances 112. Moreover, as shown in the right side of Fig. 2B, the foreign substances 112 may cause the collapse of the patterns 110. Such phenomenon do not occur when the patterns 110 and the spaces 111 have a larger width (e.g., about 56 nm).

It is believed that the foreign substances 112 are generated by reaction between ammonia in the air and fluorine remaining in the patterns 110 during the etching. In a plasma etching process for forming the patterns 110, a gas containing fluorine is often used as an etching gas, and the foreign substances 112 contain at least ammonium silicofluoride. Further, such phenomenon occurs when the silicon substrate W is left in the air for, e.g., about a month. Time duration in which such phenomenon occurs can be shortened to about 24 hours if an accelerated test is performed on the substrate W in the state shown in Fig. 2A under the condition of high humidity (of about 85%) and high temperature (of about 85°C).

In the present embodiment, the patterns 110 are recovered from the state shown in Fig. 2B to the state shown in Fig. 2C by removing the foreign substances 112 grown between the patterns 110. In this pattern recovery process, the shape of the patterns 110 is recovered by removing the foreign substances 112 by heating the silicon substrate W accommodated in a chamber to a temperature of about 160°C or higher and preferably to a temperature between about 200°C to 500°C.

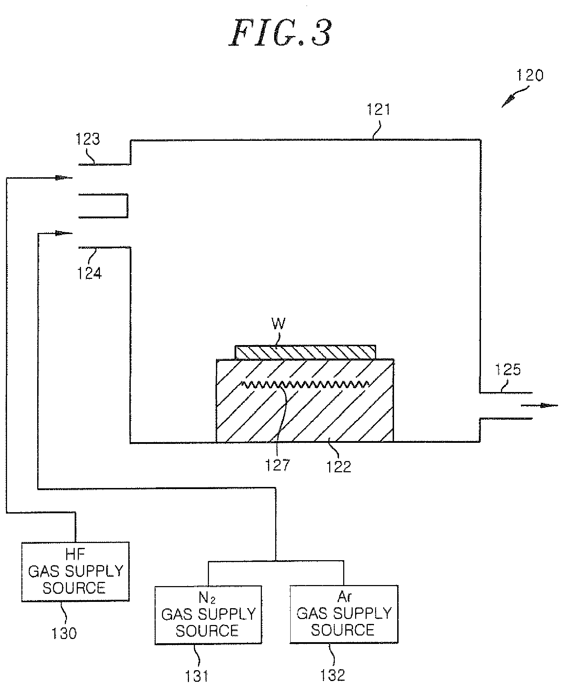

Fig. 3 shows a configuration of a pattern recovery apparatus 120 for use in recovering patterns on a silicon substrate in accordance with the present embodiment. The pattern recovery apparatus 120 for use in recovering patterns on the silicon substrate includes a chamber 121 having an inner space that can be airtightly sealed.

Installed in the chamber 121 is a mounting table 122 for mounting thereon the silicon substrate W. Further, a heater 127 serving as a heating unit is provided in the mounting table 122.

Further, provided at the chamber 121 are an HF (hydrogen fluoride) gas inlet 123 for introducing HF gas into the chamber 121, a heat treatment atmosphere gas inlet 124 for introducing a heat treatment atmosphere gas (N₂, Ar or the like), and a gas exhaust unit 125 for exhausting gas from the chamber 121. The HF gas inlet 123 is connected to an HF gas supply source 130, and the heat treatment atmosphere gas inlet 124 is connected to an N₂ gas supply source 131 and an Ar gas supply source 132. A vacuum pump (not shown) is connected to the gas exhaust unit 125.

The silicon substrate W is loaded into the chamber 121 of the pattern recovery apparatus 120 having the above-described configuration, and then is mounted on the mounting table 122. The silicon substrate W is heated to a temperature of about 160°C or higher. At this time, the inner space of the chamber 121 is preferably set to, e.g., the atmosphere of N₂ gas, Ar gas or the gaseous mixture thereof introduced from the heat treatment atmosphere gas inlet 124. Alternatively, the inner space of the chamber 121 may be set to the atmospheric atmosphere during the heating.

The melting point of ammonium silicofluoride at an atmospheric pressure is about 160°C. In order to remove the foreign substances 112 containing the ammonium silicofluoride, the heating temperature is preferably set to about 160°C or higher, and more preferably set between 200°C and 500°C. By increasing the heating temperature to about 200°C or higher, the foreign substances 112 can be effectively removed. The maximum heating temperature is set to about 500°C because the heating temperature higher than 500°C causes adverse effects on the silicon substrate W forming a semiconductor device.

In a test example 1, the patterns recovery process was performed by heating the silicon substrate W in the state shown in Fig. 2B to about 200°C in the N₂ gas atmosphere under an atmospheric pressure for about 180 seconds. As a result, the foreign substances 112 grown between the patterns 110 were removed, and the shape of the collapsed patterns 110 shown in the right side of Fig. 2B was recovered to the original state (line shape) shown in Fig. 2C. The same result was obtained even when the heating temperature was set to about 300°C.

When the heating process for recovering the patterns was performed in the atmospheric atmosphere, the patterns were insufficiently recovered at the heating temperature of about 200°C. However, the same result as that obtained in the N₂ gas atmosphere was obtained by increasing the heating temperature to about 300°C. Alternatively, the heating process may be performed in the depressurized atmosphere.

Depending on samples, the above-described heating process, by which the foreign substances 112 grown between the patterns 110 is removed, may be insufficient to recover the shape of the patterns 110. In that case, it is considered that the foreign substances 112 contain silicon dioxide by reaction between the ammonium silicofluoride and moisture in the air.

In that case, it is preferable to further perform an exposing process for exposing the silicon substrate to a HF gas atmosphere in addition to the heating process. This is because the foreign substances 112 formed of silicon dioxide can be removed by such exposing process.

In a test example 2, the patterns were recovered by performing the exposing process for exposing the silicon substrate in the state shown in Fig. 2B to the HF gas atmosphere and the heating process sequentially under the following conditions.

### (Exposing Process for exposing silicon substrate to HF gas atmosphere)

Pressure : 1330 Pa (10 Torr)
HF gas flow rate : 2800 sccm
Temperature : -10°C
Time : 60 sec
(Heating process)
Pressure : 226 Pa (1.7 Torr)
Gas flow rate : Ar = 1700 sccm + N₂ = 11.3 L/min
Temperature : 200°C
Time : 180 sec

In the test example 2, the foreign substances 112 grown between the patterns 110 were removed, and the shape of the collapsed patterns 110 shown in the right side of Fig. 2B was recovered to the original state (line shape) shown in Fig. 2C. Although the heating process is performed after the exposing process for exposing the silicon substrate to the HF gas atmosphere in the above test example 2, the exposing process may be performed after the heating process. Alternatively, the exposing process and the heating process may be performed simultaneously.

Meanwhile, when the silicon substrate is exposed to the HF gas atmosphere, defects may occur on a silicon-based material on the substrate by reaction of residual fluorine (see, e.g., Japanese Patent Application Publication No. H8-264507). To that end, there may be added a removing process for removing residual fluorine by irradiating a hydrogencontaining plasma from a plasma generator installed in the chamber 121.

In accordance with the present embodiment, it is possible to provide a method capable of recovering a shape of patterns, formed on a silicon substrate by etching, by removing foreign substances grown between the patterns.

## Claims

1. A pattern forming method comprising etching a silicon substrate by using a fluorine-containing gas thereby forming patterns on the silicon substrate, wherein the method further comprises:
exposing the silicon substrate to the air such that foreign substances are grown between the patterns; and
removing the foreign substances,
wherein the removing includes:
accommodating the silicon substrate in a chamber; and
heating the silicon substrate accommodated in a chamber to a temperature of 160°C or higher,
wherein the foreign substances contain ammonium silicofluoride generated by reaction between ammonia in the air and fluorine remaining in the patterns during the etching,
wherein, when the foreign substances contain silicon dioxide by reaction between the ammonium silicofluoride and moisture in the air, the method further comprises exposing the silicon substrate to an HF gas atmosphere, and
wherein the patterns have a line width of 32 nm or less so that the growth of the foreign substances causes the collapse of the patterns and the removal of the foreign substances causes the recovery of the patterns of the collapsed structures.

2. The method of claim 1, wherein the silicon substrate is heated in a temperature between 200°C and 500°C.

3. The method of claim 1 or 2, wherein the exposing the silicon substrate to the HF gas atmosphere and the heating the silicon substrate are performed simultaneously.

4. The method of claim 1 or 2, wherein the heating includes setting an inner space of the chamber to an atmosphere of a N₂ gas, an Ar gas or a gaseous mixture thereof.

## Patentansprüche

1. Verfahren zum Bilden eines Musters, umfassend Ätzen eines Siliziumsubstrats durch Verwenden eines Fluor enthaltenden Gases, wodurch Muster auf dem Siliziumsubstrat gebildet werden, wobei das Verfahren weiter umfasst:
Aussetzen des Siliziumsubstrats der Luft, sodass Fremdstoffe zwischen den Mustern gezüchtet werden; und
Entfernen der Fremdstoffe,
wobei das Entfernen beinhaltet:
Aufnehmen des Siliziumsubstrats in einer Kammer; und
Erhitzen des in einer Kammer aufgenommenen Siliziumsubstrats auf eine Temperatur von 160 °C oder höher,
wobei die Fremdstoffe Ammoniumsilikofluorid enthalten, das durch Reaktion zwischen Ammoniak in der Luft und während des Ätzens in den Mustern verbleibendem Fluor erzeugt wird,
wobei, wenn die Fremdstoffe Siliziumdioxid durch Reaktion zwischen dem Ammoniumsilikofluorid und Feuchtigkeit in der Luft enthalten,
das Verfahren weiter das Aussetzen des Siliziumsubstrats einer HF-Gas-Atmosphäre umfasst, und
wobei die Muster eine Linienbreite von 32 nm oder weniger aufweisen, sodass das Züchten der Fremdstoffe das Zusammenbrechen der Muster bewirkt und das Entfernen der Fremdstoffe das Wiederherstellen der Muster aus den zusammengebrochenen Strukturen bewirkt.

2. Verfahren nach Anspruch 1, wobei das Siliziumsubstrat auf eine Temperatur zwischen 200 °C und 500 °C erhitzt wird.

3. Verfahren nach Anspruch 1 oder 2, wobei das Aussetzen des Siliziumsubstrats der HF-Gas-Atmosphäre und das Erhitzen des Siliziumsubstrats gleichzeitig durchgeführt werden.

4. Verfahren nach Anspruch 1 oder 2, wobei das Erhitzen das Setzen eines Innenraums der Kammer auf eine Atmosphäre eines N₂-Gases, eines Ar-Gases oder eines gasförmigen Gemisches davon beinhaltet.

## Revendications

1. Procédé de formation de motifs comprenant la gravure d'un substrat de silicium en utilisant un gaz contenant du fluor en formant ainsi des motifs sur le substrat de silicium, le procédé comprenant en outre :
l'exposition du substrat de silicium à l'air de sorte que des substances étrangères croissent entre les motifs ; et
l'élimination des substances étrangères ;
dans lequel l'élimination inclut :
la disposition du substrat de silicium dans une chambre ; et
le chauffage du substrat de silicium disposé dans une chambre à une température égale ou supérieure à 160 °C ;
dans lequel les substances étrangères contiennent du silicofluorure d'ammonium généré par une réaction entre de l'ammoniac dans l'air et du fluor restant dans les motifs pendant la gravure ;
dans lequel, lorsque les substances étrangères contiennent du dioxyde de silicium par réaction entre le silicofluorure d'ammonium et de l'humidité de l'air,
le procédé comprend en outre l'exposition du substrat de silicium à une atmosphère de gaz HF, et
dans lequel les motifs ont une largeur de trait égale ou inférieure à 32 nm de sorte que la croissance des substances étrangères provoque l'affaissement des motifs et l'élimination des substances étrangères provoque la récupération des motifs des structures affaissées.

2. Procédé selon la revendication 1, dans lequel le substrat de silicium est chauffé à une température entre 200 °C et 500 °C.

3. Procédé selon la revendication 1 ou 2, dans lequel l'exposition du substrat de silicium à l'atmosphère de gaz HF et le chauffage du substrat de silicium sont effectués simultanément.

4. Procédé selon la revendication 1 ou 2, dans lequel le chauffage inclut le réglage d'un espace intérieur de la chambre à une atmosphère d'un gaz N₂, d'un gaz Ar ou d'un mélange gazeux de ceux-ci.
